# EUROPÄISCHE PATENTANMELDUNG

(11) **EP 4 174 928 A1**
(43) Veröffentlichungstag der Anmeldung: **03.05.2023**
(21) Anmeldenummer: 21205313.6
(22) Anmeldetag: 28.10.2021
(51) Int. Cl.: H01L 23/053, H01L 23/10, H01L 25/07, H01L 25/18

(54) **HALBLEITERBAUELEMENT MIT GEDÄMPFTEN BONDFLÄCHEN IN EINEM GEHÄUSE MIT UMSPRITZTEN PINS**

(71) Anmelder: Siemens Aktiengesellschaft, 80333 München (DE)
(72) Erfinder: Kürten, Bernd, 90587 Obermichelbach (DE); Kappauf, Daniel, 91322 Gräfenberg (DE)
(74) Vertreter: Siemens Patent Attorneys

(57) **Zusammenfassung**

Bei einem Halbleiterbauelement (1) mit einem Gehäuse mit umspritzten Pins (3) sollen einfach und zuverlässig Bondverbindungen zwischen Bondflächen (4) der Pins (3) und Halbleiter-Bondflächen (8) eines Halbleiterelements (7) des Halbleiterbauelements (1) hergestellt werden.

Die Erfindung sieht daher ein Gehäuse-Teil (2) zur Aufnahme eines Halbleiterelements (7) vor, wobei das Gehäuse-Teil (2) wenigstens einen teilweise in das Gehäuse-Teil (2) eingegossenen (3) zur elektrischen Verbindung mit einer Leiterplatte umfasst, wobei der Pin (3) eine Bondfläche (4) zur Herstellung einer elektrischen Verbindung zwischen dem Pin (3) und dem Halbleiterelement (7) umfasst, wobei das Gehäuse-Teil (2) eine Auflagefläche (5) für die Bondfläche (4) umfasst und wobei das Gehäuse-Teil (2) in der Auflagefläche (5) oder an die Auflagefläche (5) angrenzend eine Aussparung (12) aufweist, wobei die Aussparung zumindest teilweise mit einem schwingungsdämpfenden Material (10) gefüllt ist und/oder in einem an die Aussparung (12) angrenzenden Bereich schwingungsdämpfendes Material (10) aufgebracht ist.

Die Erfindung bietet den Vorteil, dass durch die gedämpfte Lagerung der Bondfläche (4) das Gehäuse-Teil (2) zur Aufnahme eines Halbleiterelements (7) einteilig ausgebildet werden kann und dennoch die darin eingegossene Pins (3) mittels Ultraschallbonden kontaktiert werden können.

## Beschreibung

Gehäuse für Halbleiterbauelemente umfassen in der Regel mehrere Gehäuse-Teile, z.B. eine Gehäuse-Grundplatte (Bodenplatte), ein oder mehrere Gehäuse-Rahmenteile und einen GehäuseDeckel. Die einzelnen Gehäuse-Teile werden i.d.R. miteinander verklebt, so dass ein Halbleiterelement, z.B. ein integrierter Schaltkreis, oder mehrere Halbleiterelemente im Inneren des Gehäuses vollständig von dem Gehäuse umschlossen ist bzw. sind.

Halbleiterbauelemente (Transistoren, Triacs, Thyristoren, Dioden etc) werden i.d.R. auf einer Platine aufgebracht, insbesondere mit dieser verlötet. Zur elektrischen Kontaktierung weist ein Halbleiterbauelement i.d.R. aus dem Gehäuse-Inneren nach außen geführte elektrische Kontakte, sogenannte Pins auf.

Häufig werden mehrere derartige Halbleiterbauelemente zum Erfüllen eines bestimmten Zwecks miteinander verschaltet. Sie bilden eine elektronische Baugruppe, z.B. einen Stromrichter.

Innerhalb des Gehäuses für ein Halbleiterelement erfolgt i.d.R. eine elektrische Verbindung zwischen Bondflächen der Pins und Bondflächen des Halbleiterelements durch Drahtbonden. Ein gängiges Verfahren ist dabei das Ultraschall-Drahtbonden, bei dem die Bondflächen und der Bonddraht durch Druck und Ultraschallschwingungen miteinander verschweißt werden.

Zum Erlangen bestimmter Material-Eigenschaften können zum Spritzgießen verwendeten Kunststoffe durch Additive oder Füllstoffe, z.B. Teilchen oder Partikel, angereichert, also "gefüllt" werden. So ist es üblich, dass z.B. durch Spritzguss hergestellte Kunststoffgehäuse für Halbleiterbauelemente mit einem mehr oder weniger hohen Anteil an anorganischen Partikeln und Glasfasern als Füllstoff "gefüllt" sind.

Ein höherer Füllungs-Anteil macht die Gehäuse einerseits beständiger gegenüber hohen Temperaturen, andererseits jedoch auch härter, was nicht immer erwünscht ist.

Zum Einbringen der Pins in ein Gehäuse gibt es verschiedene Möglichkeiten. Eine Variante sieht vor, dass in einem Gehäuse-Teil, insbesondere einem ersten Gehäuse-Rahmenteil, Aussparungen vorgesehen werden, in die die Pins anschließend eingesteckt werden. Zur Befestigung der Pins und zur Ausbildung von Auflageflächen unterhalb der Bondflächen der Pins wird anschließend ein zweites Gehäuse-Rahmenteil mit dem ersten Gehäuse-Rahmenteil verklebt, so dass die Pins in dem Gehäuse befestigt und fixiert sind. Dabei lässt es sich bewerkstelligen, dass sich unterhalb der Bondflächen der Pins Klebstoff zur Ausbildung der Auflageflächen für die Bondflächen befindet, was beim Ultraschall-Drahtbonden eine schwingungsdämpfende Wirkung hat.

Diese Vorgehensweise ist jedoch relativ aufwendig, da für ein Gehäuse zwei Gehäuse-Rahmenteile gefertigt und miteinander verklebt werden müssen. Außerdem müssen die Pins im Anschluss an die Fertigung des ersten Gehäuse-Rahmenteils erst in die dafür vorgesehenen Aussparungen gesteckt werden, was einen zusätzlichen Arbeitsschritt bei der Herstellung bedeutet.

Einfacher und damit kostengünstiger ist es daher, die Pins direkt bei der Herstellung des Gehäuse-Teils, insbesondere in einem Spritzguss-Verfahren, mit Kunststoffmaterial zu umspritzen, so dass die Pins direkt bei der Herstellung des Gehäuse-Teils teilweise in das Gehäuse-Teil eingegossenen und so mit diesem verbunden werden. Auch entsprechende Auflageflächen für die Bondflächen der Pins werden in demselben Arbeitsgang und mit demselben (Spritzguss-) Material hergestellt.

Neben den bereits genannten Vorteilen hat diese Vorgehensweise jedoch den Nachteil, dass insbesondere bei einem Gehäuse-Material mit einem hohen Füllstoffanteil beim Ultraschall-Drahtbonden die Bondflächen der Pins zu unerwünschten Schwingungen (Resonanzen) angeregt werden, so dass die gewünschte Schweißverbindung zwischen dem Bonddraht und der Bondfläche nicht oder nicht mit der geforderten Qualität zustande kommt.

Eine Aufgabe der vorliegenden Erfindung ist es daher, bei einem Gehäuse-Teil mit eingegossenen (umspritzten) Pins in einfacher und kostengünstiger Weise Ultraschall-Schweißverbindungen mit hoher Qualität zu ermöglichen.

Diese Aufgabe wird durch ein Gehäuse-Teil mit den Merkmalen gemäß Anspruch 1 gelöst, also ein Gehäuse-Teil zur Aufnahme eines Halbleiterelements,
wobei das Gehäuse-Teil wenigstens einen teilweise in das Gehäuse-Teil eingegossenen Pin zur elektrischen Verbindung mit einer Leiterplatte umfasst,
wobei der Pin eine Bondfläche zur Herstellung einer elektrischen Verbindung zwischen dem Pin und dem Halbleiterelement umfasst,
wobei das Gehäuse-Teil eine Auflagefläche für die Bondfläche umfasst,
wobei das Gehäuse-Teil in der Auflagefläche oder an die Auflagefläche angrenzend eine Aussparung aufweist und
wobei die Aussparung zumindest teilweise mit einem schwingungsdämpfenden Material gefüllt ist und/oder in einem an die Aussparung angrenzenden Bereich schwingungsdämpfendes Material aufgebracht ist.

Das erfindungsgemäße Gehäuse-Teil ist durch die eingegossenen (umspritzten) Pins einfach und kostengünstig herstellbar. Weiterhin sind die Auflageflächen für die Bondflächen aus demselben Gehäuse-Material und sie werden in demselben Fertigungsschritt gemeinsam mit dem übrigen Gehäuse-Teil hergestellt. Insbesondere müssen weder zwei getrennte Gehäuse-Rahmenteile hergestellt noch diese mittels Klebverbindung miteinander verbunden werden.

Durch die Einbringung wenigstens einer Aussparung in oder angrenzend an eine Auflagefläche wird die Auflagefläche von dem übrigen Gehäuse-Rahmenteil mechanisch bzw. schwingungstechnisch entkoppelt. Das Auffüllen der Aussparungen mit schwingungsdämpfendem Material bzw. das Aufbringen von schwingungsdämpfendem Material in einem an die Aussparung angrenzenden Bereich dämpft unerwünschte Schwingungen, insbesondere Resonanzen, zusätzlich. Insbesondere werden unerwünschte Schwingungen soweit gedämpft bzw. unterdrückt, dass die gewünschte Qualität der Schweißverbindungen beim Ultraschall-Drahtbonden erreicht wird.

Eine Ausführungsform der Erfindung sieht vor, dass die Aussparung als Nut zwischen der Auflagefläche und dem übrigen Gehäuse-Teil ausgebildet ist. Die Aussparung bzw. Nut wird vorzugsweise bei der Konstruktion des Gehäuse-Teils mit eingeplant, so dass diese direkt bei der Herstellung des Gehäuse-Teils, insbesondere in einem Spritzgussvorgang, entsteht. Alternativ wäre es auch denkbar, die Aussparung bzw. Nut in einem an den Spritzgussvorgang anschließenden Arbeitsgang, z.B. durch ein materialabtragendes Verfahren, herzustellen.

Die Nut bewirkt, dass es im Bereich der Nut zu einer Verengung der Materialstärke (Engstelle) des Gehäuse-Teils kommt, wodurch die Auflagefläche elastisch verformbar mit dem übrigen Gehäuse-Teil verbunden ist bzw. die Auflagefläche von dem übrigen Gehäuse-Teil mechanisch bzw. schwingungstechnisch weitgehend entkoppelt ist.

Allgemein bewirkt eine Aussparung durch die Reduzierung von Material eine geringere Steifigkeit und damit einhergehend verbesserte Elastizität.

Durch ein wenigstens teilweises Ausfüllen der Aussparung bzw. Nut mit einem schwingungsdämpfenden, insbesondere im Vergleich zu dem Gehäuse-Material verhältnismäßig weichen bzw. elastischen Material, werden so bei dem Ultraschall-Schweißvorgang auf die Bondfläche übertragene Schwingungen bzw. Resonanzen gedämpft.

Zusätzlich oder alternativ zu dem Ausfüllen der Aussparung bzw. Nut kann das schwingungsdämpfende Material auch in einem an die Aussparung bzw. Nut angrenzenden Bereich außerhalb der Aussparung bzw. Nut appliziert werden. Beispielsweise kann das schwingungsdämpfende Material in einem unmittelbar an die Nut angrenzenden Bereich in einen Spalt zwischen der Auflagefläche und einer Bodenplatte eingebracht werden.

Vorteilhaft kann die schwingungsdämpfende Wirkung über die Menge des applizierten schwingungsdämpfenden Materials, insbesondere über die Schichtdicke, beeinflusst bzw. "eingestellt" werden.

Als schwingungsdämpfendes Material wird vorzugsweise Klebstoff (Kleber) verwendet. Vorteilhaft kann der Klebstoff in demselben Arbeitsgang aufgebracht werden, in dem auch der Klebstoff zur Verbindung des Gehäuse-Teils mit einem Halbleiter-Träger, insbesondere einer Bodenplatte, auf das Gehäuse-Teil aufgebracht wird. Vorteilhaft können mit demselben Klebstoff beide Funktionen (Kleben und Dämpfen) erfüllt werden.

Eine Ausführungsform der Erfindung sieht vor, dass die Bondfläche an einem Ende des Pins ausgebildet ist und der Pin zwischen der Bondfläche und einer am gegenüberliegenden Ende des Pins angeordneten Kontaktfläche eine Biegung von zumindest näherungsweise 90° aufweist. Diese Ausführungsform ist üblich bei Halbleiterbauelementen, bei denen die Pins an der Ober- oder Unterseite (und nicht seitlich) aus dem Gehäuse geführt sind. Diese Ausführungsform bietet die Möglichkeit, dass eine von oben auf die Bondfläche ausgeübte Kraft um 90° umgelenkt in das Gehäuse-Teil eingeleitet wird. Für die Nut und das Dämpfungsmaterial wird so kein zusätzlicher Bauraum im dem Gehäuse-Teil benötigt.

Bei Halbleiterbauelementen ist es üblich, dass das Gehäuse-Teil nicht nur einen Pin, sondern mehrere unmittelbar nebeneinander angeordnete Pins mit je einer Bondfläche und einer Auflagefläche aufweist.

Eine Ausführungsform der Erfindung sieht vor, dass benachbarte Auflageflächen, die jeweils mit wenigstens einer Aussparung und schwingungsdämpfendem Material versehen sind, jeweils durch einen Spalt voneinander getrennt sind. Zwar wird eine schwingungsdämpfende Wirkung auch dann schon erreicht, wenn benachbarte Auflageflächen nicht durch einen Spalt voneinander getrennt sind, die schwingungsdämpfende Wirkung kann jedoch dadurch erhöht werden, dass benachbarte Auflageflächen durch einen seitlichen Spalt zwischen den Auflageflächen voneinander getrennt werden. Derart ausgestaltete Auflageflächen können so unerwünschte Schwingungen noch besser absorbieren.

Eine Ausführungsform der Erfindung sieht vor, dass das Gehäuse-Material ein mit einem Füllstoff, insbesondere Glasfasern und/oder Partikeln verstärkter ("gefüllter") Kunststoff, insbesondere Epoxidharz, ist oder einen mit einem Füllstoff, insbesondere Glasfasern und/oder Partikeln, verstärkten Kunststoff, insbesondere Epoxidharz, aufweist. Dadurch können in einem Spritzguss-Vorgang herstellbare und eine hohe thermische Stabilität aufweisende Gehäuse-Teile gefertigt werden.

Die Erfindung kann bei einer Vielzahl verschiedener Halbleiterbauelemente, z.B. Insulated-Gate Bipolar Transistoren, angewendet werden, die sich durch ein erfindungsgemäßes Gehäuse-Teil auszeichnen. Besonders vorteilhaft wirkt sich die Erfindung aus bei Wide Band Gap Halbleitern, insbesondere SiC Mosfest, da insbesondere bei diesen besonders temperaturbeständige und damit wenig elastische bzw. spröde Gehäuse benötigt werden.

Die eingangsgestellte Aufgabe wird ferner gelöst durch ein Verfahren mit den Verfahrensschritten gemäß Anspruch 9, also ein Verfahren zur Herstellung eines Gehäuse-Teils zur Aufnahme eines Halbleiterelements,
wobei wenigstens ein Pin zur elektrischen Verbindung mit einer Leiterplatte wenigstens teilweise in das Gehäuse-Teil eingegossen wird,
wobei an dem Pin eine Bondfläche zur Herstellung einer elektrischen Verbindung zwischen dem Pin und dem Halbleiterelement ausgebildet wird,
wobei an dem Gehäuse-Teil eine Auflagefläche für die Bondfläche ausgebildet wird,
wobei in dem Gehäuse-Teil in der Auflagefläche oder an die Auflagefläche angrenzend eine Aussparung ausgebildet wird und
wobei die Aussparung zumindest teilweise mit einem schwingungsdämpfenden Material gefüllt ist und/oder in einem an die Aussparung angrenzenden Bereich schwingungsdämpfendes Material aufgebracht ist.

Die Vorteile des erfindungsgemäßen Verfahrens sind, dass Halbleiterbauelemente mit einer geringen Anzahl unterschiedlicher Gehäuse-Teile und einer geringen Anzahl an Fertigungsschritten hergestellt und trotz eines hohen Füllstoff-Anteils in dem Gehäusematerial zuverlässig Bond-Verbindungen von hoher Qualität erzeugt werden können. Insbesondere werden bei dem Herstellungsverfahren unerwünschte Resonanzen beim Bonden unterdrückt.

Vorteilhafte Ausführungsformen des erfindungsgemäßen Verfahrens sehen vor, dass die Aussparung als Nut ausgebildet wird, dass die Aussparung bei der Herstellung des Gehäuse-Teils in einem Spritzguss-Verfahren hergestellt wird oder dass in die Aussparung oder in einem an die Aussparung angrenzenden Bereich ein schwingungsdämpfendes Material, insbesondere ein Kleber ein- bzw. aufgebracht wird.

Die Ausbildung einer Nut kann unmittelbar bei der Herstellung des Gehäuse-Teils durch das Spritzguss-Verfahren hergestellt werden. Auch das Ein- bzw. Aufbringen des Klebers als schwingungsdämpfendes Material kann in Verbindung mit einem ohnehin erforderlichen Klebstoff-Auftrag auf das Gehäuse-Teil erfolgen. Es sind daher für die genannten Maßnahmen keine zusätzlichen Verfahrensschritte erforderlich.

Insbesondere wird vorteilhaft das Halbleiterelement auf einem Halbleiter-Träger, z.B. einer Bodenplatte aus Kupfer, und auf das Gehäuse-Teil ein Kleber aufgebracht zur Verbindung des Halbleiter-Trägers mit dem Gehäuse-Teil, wobei vorzugsweise in demselben Arbeitsgang der Kleber in die Aussparung eingebracht bzw. im Bereich der Aussparung aufgebracht wird und wobei der Halbleiter-Träger mittels des Klebers in das Gehäuse-Teil eingeklebt wird.

Vorteilhaft weist im Zusammenhang mit der Erfindung das Halbleiterelement eine Halbleiter-Bondfläche auf und die Bondfläche (des Pins) und die Halbleiter-Bondfläche werden mittels Drahtbonden, insbesondere Ultraschall-Drahtbonden miteinander verbunden bzw. verschweißt.

Durch die Erfindung ist es auch bei relativ harten und unelastischen Gehäuse-Teilen mit einem hohen Füllstoffanteil möglich, Bond-Verbindungen von hoher Qualität zu erzielen, ohne dass hierfür zusätzliche Arbeitsschritte erforderlich sind.

Die eingangsgestellte Aufgabe wird weiterhin gelöst durch ein Halbleiterbauelement nach Anspruch 7, umfassend ein Gehäuse-Teil zur Aufnahme eines Halbleiterelements nach einem der Ansprüche 1 bis 6 sowie ein Halbleiterelement.

Die Erfindung wird nachfolgend anhand von Ausführungsbespielen näher erläutert. Es zeigen:
- FIG 1: ein Halbleiterbauelement mit einem geöffneten Gehäuse,
- FIG 2: einen Querschnitt eines Halbleiterbauelements gemäß FIG 1 gemäß dem Stand der Technik,
- FIG 3: einen Querschnitt eines weiteren Halbleiterbauelements gemäß FIG 1 gemäß dem Stand der Technik,
- FIG 4: einen Querschnitt eines Halbleiterbauelements gemäß FIG 1 gemäß der Erfindung,
- FIG 5: eine Anordnung nebeneinanderliegender Pins,
- FIG 6: einen Querschnitt einer weiteren Ausführungsform eines Halbleiterbauelements gemäß der Erfindung,
- FIG 7: einen Querschnitt einer weiteren Ausführungsform eines Halbleiterbauelements gemäß der Erfindung und
- FIG 8: Verfahrensschritte bei der Ausführung eines erfindungsgemäßen Verfahrens.

Zum besseren Verständnis der Erfindung werden nachfolgend gleiche Bauteile mit denselben Bezugszeichen versehen.

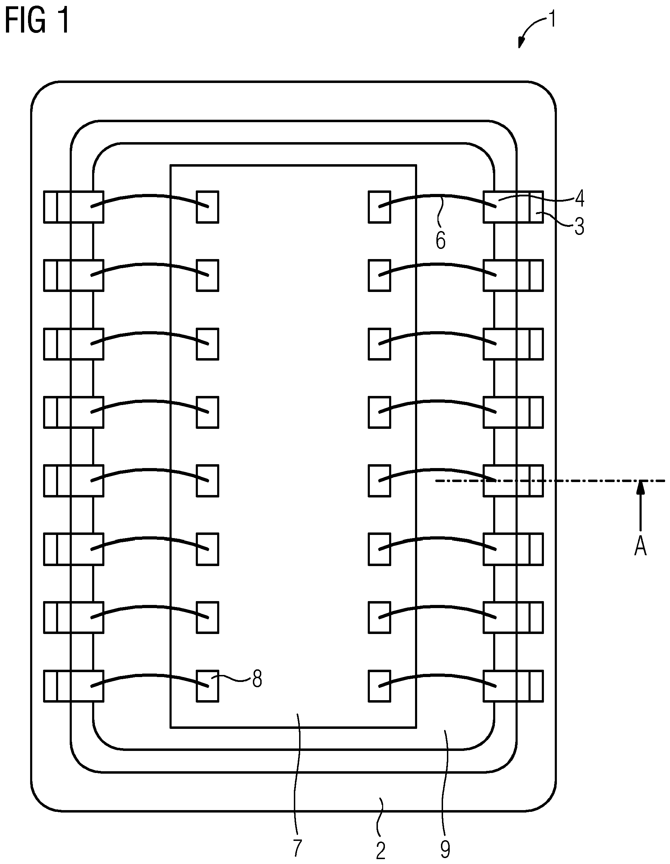

FIG 1 zeigt ein geöffnetes Halbleiterbauelement 1 in einer Draufsicht. Dabei sind in einem Gehäuse-Teil 2, insbesondere einem Gehäuse-Rahmenteil 2, links und rechts jeweils eine Reihe von Pins 3 zur elektrischen Kontaktierung des Halbleiterbauelements 1 zum Beispiel mit einer Leiterplatte (nicht dargestellt) ersichtlich. In das Gehäuse-Rahmenteil 2 ist ein Halbleiter-Träger 9, insbesondere eine Bodenplatte 9 eingefügt, die ein Halbleiterelement 7, zum Beispiel einen integrierten Schaltkreis 7 trägt. Das Halbleiterelement 7 ist an seiner Oberseite mit Halbleiter-Bondflächen 8 versehen. Zur elektrischen Verbindung der Pins 3, insbesondere der Bondflächen 4 der Pins 3, mit den Halbleiter-Bondflächen 8 des Halbleiterelements 7 sind Bonddrähte 6 vorgesehen, die zum Beispiel in einem Ultraschall-Drahtbond-Verfahren mit den Bondflächen 4 verschweißt werden.

Bei dem Halbleiterbauelement 1 gemäß Fig 1 kann es sich sowohl um ein herkömmliches Halbleiterbauelement gemäß dem Stand der Technik als auch um ein erfindungsgemäßes Halbleiterbauelement handeln. Die Erfindung ist aus dieser Ansicht nicht ersichtlich.

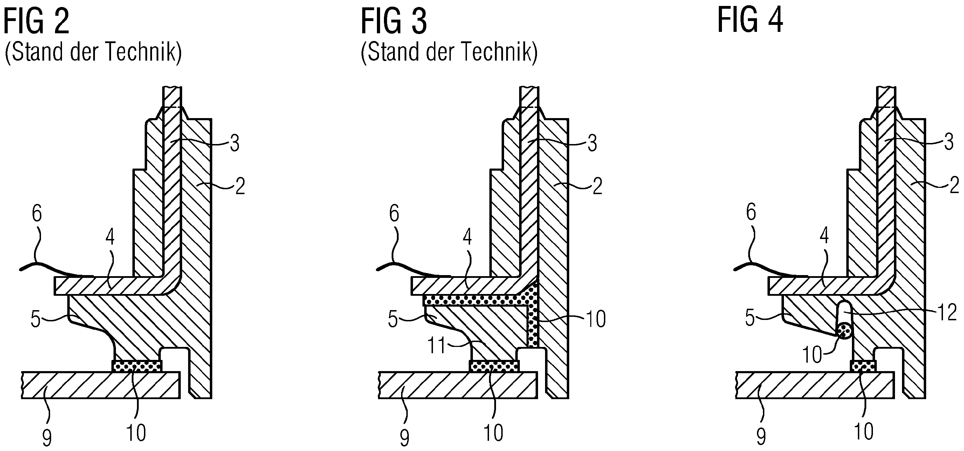

Die Figuren 2-7 zeigen unterschiedliche Ausführungsformen des Halbleiterbauelements 1 an einer aus FIG 1 ersichtlichen Schnittlinie A.

Fig 2 zeigt eine erste Ausführungsform zur elektrischen Verbindung von in dem Gehäuse-Randteil 2 angeordneten Pins 3 mit dem Halbleiterelement (in FIG 2 nicht dargestellt) gemäß dem Stand der Technik. Zur Aufnahme einer bei einem Bondvorgang auf die Bondfläche 4 des Pins 3 ausgeübten Kraft befindet sich unterhalb der Bondfläche 4 eine Auflagefläche 5 für die Bondfläche 4.

Als Bondfläche 4 wird dabei nicht nur die zum Bonden verwendete Oberfläche des Pins 3 verstanden, sondern der gesamte vordere Bereich des Pins 3, in dem auch die beim Bonden verwendete Oberfläche liegt.

Bei der Auflagefläche 5 handelt es sich gewöhnlich um eine einteilig mit dem Gehäuse verbundene und aus demselben Gehäuse-Material wie das übrige Gehäuse-Rahmenteil 2 bestehende Ausformung bzw. Ausbuchtung des Gehäuse-Rahmenteils 2.

Weiterhin ist aus der FIG 2 die Bodenplatte 9 ersichtlich, auf der das Halbleiterelement (nicht dargestellt) aufgebracht ist. Die Bodenplatte 9 und das Gehäuse-Rahmenteil 2 sind mittels einer Kleberverbindung, insbesondere durch den Kleber 10 miteinander verbunden.

Bei dem Bondvorgang, insbesondere beim Ultraschall-Drahtbonden bzw. Ultraschallschweißen, z.B. dem Ultraschall-Wedge-Wedge-Bonden, werden der Bonddraht 6 und die Bondfläche 4 durch Kraftauftrag in Verbindung mit UltraschallSchwingungen miteinander verschweißt. Dabei können unter ungünstigen Umständen Resonanzen angeregt werden, die die Verbindung zwischen dem Bonddraht 6 und der Bondfläche 4 gänzlich oder zumindest in der geforderten Qualität verhindern. Dies ist insbesondere dann der Fall, wenn Gehäuse-Materialien mit einem hohen Füllstoffanteil, z.B. mit einem hohen Glasfaseranteil verwendet werden, da die resultierenden Gehäuse härter und damit weniger elastisch sind.

Eine Abhilfe für dieses Problem zeigt FIG 3, wobei bei dieser aus dem Stand der Technik bekannten Lösung anstatt eines einteiligen Gehäuse-Rahmenteils ein erstes Gehäuse-Rahmenteil 2 und ein zweites Gehäuse-Rahmenteil 11 verwendet werden. Die beiden Gehäuse-Rahmenteile 2 und 11 werden in getrennten Herstellungsprozessen hergestellt und anschließend durch Aufbringen des Klebers 10 und zusammenfügen der Teile miteinander verklebt. Der gesamte Herstellungsprozess ist demnach bei dieser Variante deutlich aufwendiger als bei der erstgenannten. Allerdings hat diese Ausführungsform den Vorteil, dass dabei zwischen der Auflagefläche 5 und der Bondfläche 4 im Zusammengang mit dem Verkleben der beiden Gehäuseteile 2 und 11 eine Kleber-Schicht 10 zwischen der Auflagefläche 5 und dem zweiten Gehäuse-Rahmenteil 11 eingefügt werden kann, die für eine weiche und elastische Lagerung der Bondfläche 4 sorgt. Beim Ultraschall-Drahtbonden auftretende Resonanzen werden so gedämpft, was zu Schweißverbindungen in der gewünschten Qualität führt.

Aus FIG 4 ist nun eine erfindungsgemäße Ausführungsform des betreffenden Gehäuse-Rahmenteils 2 ersichtlich. Im Unterschied zu der Ausführungsform gemäß FIG 3 ist hier jedoch der Gehäuserahmen durch das Gehäuse-Rahmenteil 2 einteilig ausgeführt. Um dennoch die gewünschte schwingungsgedämpfte Lagerung der Auflagefläche 4 zu gewährleisten, ist eine (Gehäuse-) Aussparung 12 in Form einer Nut 12 vorgesehen. Diese Nut 12 sorgt dafür, dass die Auflagefläche 5 elastisch federn kann.

Um unerwünschte Resonanzen wirkungsvoll zu unterdrücken, ist eine Dämpfung der Auflagefläche 5 vorgesehen. Die Dämpfungswirkung wird besonders vorteilhaft dadurch erreicht, dass in die Nut 12 ein schwingungsdämpfendes Material, insbesondere Kleber 10 eingeführt wird. Der Kleber 10 ist in seiner Konsistenz so beschaffen, dass die gewünschte dämpfende Wirkung erreicht wird.

Die Verwendung des Klebers 10 zur Dämpfung hat weiterhin den Vorteil, dass auf das Gehäuse-Rahmenteil 2 ohnehin Klebstoff 10 aufgebracht werden muss, nämlich zur Verbindung des Gehäuse-Rahmenteils 2 mit der Bodenplatte 9, die das Halbleiterelement (nicht dargestellt) trägt. Dies bedeutet, dass für den zur Dämpfung vorgesehenen Kleber 10 weder ein zusätzlicher Arbeitsgang zum Auftragen des Klebers 10 noch zusätzlicher Bauraum in dem Gehäuse-Rahmenteil 2 benötigt werden.

Besonders vorteilhaft ist der Klebstoff seitens seiner Materialzusammensetzung derart beschaffen, dass er sowohl die gewünschte klebende als auch schwingungsdämpfende Wirkung erfüllt. Ein- und derselbe Klebstoff kann so sowohl als Kleber als auch als Dämpfer verwendet werden.

Die zum Ultraschallbonden erforderliche Kraft wird bei dieser Ausführungsform senkrecht auf die Grundfläche 4 aufgebracht und über die Nut 12, die eine Art Scharnierwirkung erzielt, und den Kleber 10 um 90° umgelenkt und seitlich - in schwingungsgedämpfter Form - in das Gehäuse-Rahmenteil 2 eingeleitet.

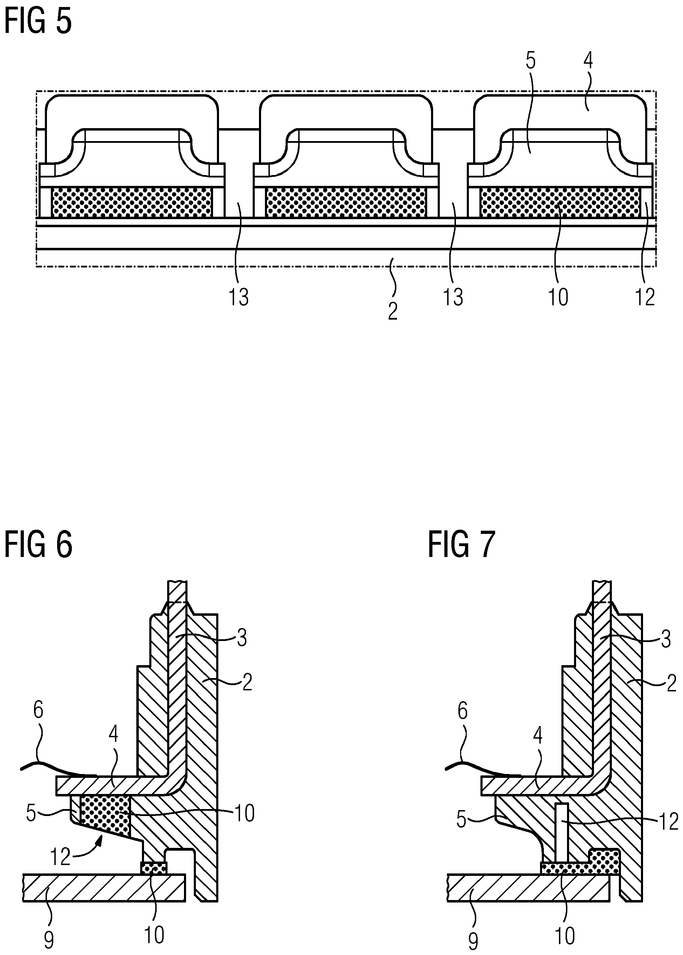

FIG 5 zeigt eine Ausführungsform der Erfindung gemäß Figur 4 von der Unterseite des Gehäuse-Rahmenteils 2 her betrachtet. Im Unterschied zu FIG 4 sind hier jedoch 3 nebeneinanderliegende Pins dargestellt, von denen jeweils das vordere Ende der Bondfläche 4 ersichtlich ist. Aus der Figur sind weiterhin jeweils die Auflagefläche 5, die Nut 12 und der in die Nut 12 eingebrachte Kleber 10 zu erkennen.

Um die elastische Verformbarkeit der Auflageflächen 5 weiter zu erhöhen, sieht die Ausführungsform gemäß FIG 5 vor, dass die Auflageflächen 5 benachbarter Pins nicht direkt miteinander verbunden sind. Im Unterschied zu bisherigen Lösungen, bei denen das Gehäuse-Rahmenteil häufig einen durchgängigen "Balkon" als Auflagefläche für die Bondflächen der Pins aufweist, ist hier zwischen benachbarten Pins jeweils ein Spalt 13 vorgesehen, der die Auflageflächen 5 benachbarten Pins voneinander trennt. So können benachbarte Pins bzw. deren Auflageflächen 5 unabhängig voneinander schwingen, was zusätzlich dazu beiträgt, unerwünschte Resonanzen zu dämpfen bzw. zu unterbinden. Es sei an dieser Stelle jedoch angemerkt, dass es sich bei dieser Ausführungsform lediglich um eine bestimmte Variante der Erfindung handelt, die seitlichen Spalte 13 bei vielen Anwendungen jedoch nicht zwingend erforderlich sind.

Weiterhin wird angemerkt, dass die Spalte 13 derart positioniert und orientiert sind, dass sie direkt bei der Herstellung des Gehäuse-Rahmenteils 2 ausgebildet werden können. Zur Erzeugung der Spalte 13 ist somit kein zusätzlicher Arbeitsschritt bei der Herstellung des Gehäuse-Rahmenteils 2 erforderlich.

Eine weitere Ausführungsform der Erfindung zeigt FIG 6. Im Unterschied zu der Ausführungsform gemäß FIG 5 ist hier jedoch die Aussparung 12 nicht in Form einer Nut, sondern als Loch 12 in der Auflagefläche 5 ausgeführt.

Im Ausführungsbeispiel ist das Loch 12 durchgängig ausgebildet und reicht bis zur Bondfläche 4 des Pins. Es sind jedoch auch andere Ausführungsformen, z.B. als Sackloch, möglich.

Auch hier ist zur besseren Schwingungsdämpfung ein schwingungsdämpfendes Material vorgesehen. Insbesondere ist das Loch 12 mit Kleber 10 ausgefüllt.

Auch bei dieser Ausführungsform gemäß FIG 6 kann das Loch 12 in der Auflagefläche 5 direkt bei der Herstellung des Gehäuse-Rahmenteils 2, insbesondere mittels eines SpritzgussVerfahrens hergestellt und beim Auftragen des Klebers 10 zur Verbindung des Gehäuse-Rahmenteils 2 mit der Bodenplatte 9 in einem Arbeitsgang mit Kleber 10 gefüllt werden. Auch bei dieser Ausführungsform sind somit gegenüber den bei der Herstellung ohnehin erforderlichen Verfahrensschritten keine zusätzlichen Verfahrensschritte erforderlich. Die beabsichtigte Wirkung kann daher auch hier besonders effizient und kostengünstig erzielt werden.

Eine weitere Ausführungsform der Erfindung zeigt FIG 7. Auch hier ist - ähnlich zu der Ausführungsform gemäß FIG 4 - eine Nut 12 unterhalb der Auflagefläche 4 ausgebildet. Im Unterschied zu der Ausführungsform gemäß FIG 4 ist bei der Ausführungsform gemäß FIG 7 jedoch das dämpfende Material in Form des Kleber 10 nicht direkt in die Nut appliziert, sondern der Kleber 12 befindet sich hier in einem (unmittelbar) an die Nut 12 angrenzenden Bereich in einem Spalt zwischen dem Gehäuse-Rahmenteil 2 und der Bodenplatte 9.

Diese Ausführungsform bietet den Vorteil, dass noch weniger Ultraschallenergie an dem Gehäuse-Rahmenteil 2 ankommt, da diese durch die Verbindung zwischen dem Gehäuse-Rahmenteil 2 und der Bodenplatte 9 zumindest teilweise auf die Bodenplatte 9 abgeleitet wird.

Außerdem kann es bei schmalen Aussparungen bzw. Nuten dispenstechnisch schwierig sein, den Kleber 10 in die Aussparung bzw. Nut 12 einzubringen. Bei der Lösung gemäß FIG 7 kann der Kleber 12 in einer verhältnismäßig breiten Spur und damit dispenstechnisch einfach auf das Gehäuse-Rahmenteil 2 aufgebracht werden. Die dämpfende Wirkung, die sich aus der Kombination von Nut und dämpfendem Material ergibt, kann so in besonders einfacher Weise, insbesondere ohne zusätzliche oder komplizierte Verfahrensschritte bei der Herstellung, erreicht werden.

Die Dämpfung kann auch hier vorteilhaft über die Schichtdicke der Kleberschicht eingestellt werden.

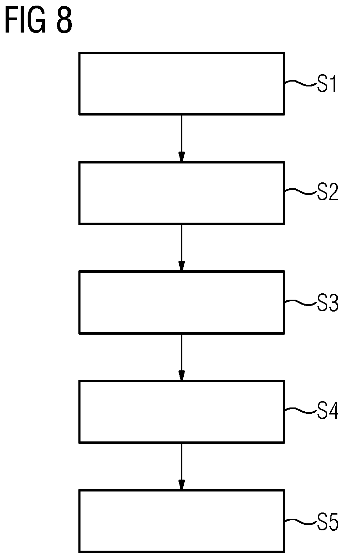

Fig 8 zeigt bei der Herstellung eines erfindungsgemäßen Halbleiterbauelements erforderliche Verfahrensschritte:
In einem ersten Verfahrensschritt S1 werden mit jeweils einer Bondfläche versehene Pins aus einem elektrisch leitfähigen Material hergestellt.

In einem zweiten Verfahrensschritt S2 werden die Pins mit Kunststoffmaterial umspritzt, insbesondere mittels eines Spritzgussverfahrens, derart, dass ein Gehäuse-Rahmenteil mit darin eingegossenen Pins entsteht, wobei das Gehäuse-Rahmenteil derart konstruiert ist, dass eine unterhalb der Bondfläche eines Pins ausgebildete Auflagefläche mit einer Aussparung, insbesondere einer Nut versehen ist.

In einem dritten Verfahrensschritt S3 werden auf das Gehäuse-Rahmenteil Klebstoff aufgebracht und in die Aussparung Klebstoff als Dämpfungsmaterial eingebracht oder Klebstoff in einem an die Aussparung anschließenden Bereich aufgebracht. Anschließend werden das Gehäuse-Rahmenteil und eine Bodenplatte, die wenigstens ein Halbleiterelement trägt, zusammengefügt und mittels des zuvor aufgebrachten Klebers miteinander verklebt.

In einem vierten Verfahrensschritt S4 werden die Bondflächen der Pins mit Bondflächen des Halbleiterelements mittels eines Ultraschall-Drahtbond-Verfahrens miteinander verbunden, insbesondere verschweißt.

In einem fünften Verfahrensschritt S5 wird das Gehäuse-Rahmenteil mit einem Gehäusedeckel verklebt.

## Patentansprüche

1. Gehäuse-Teil (2) zur Aufnahme eines Halbleiterelements (7),
wobei das Gehäuse-Teil (2) wenigstens einen teilweise in das Gehäuse-Teil (2) eingegossenen Pin (3) zur elektrischen Verbindung mit einer Leiterplatte umfasst,
wobei der Pin (3) eine Bondfläche (4) zur Herstellung einer elektrischen Verbindung zwischen dem Pin (3) und dem Halbleiterelement (7) umfasst,
wobei das Gehäuse-Teil (2) eine Auflagefläche (5) für die Bondfläche (4) umfasst und
wobei das Gehäuse-Teil (2) in der Auflagefläche (5) oder an die Auflagefläche (5) angrenzend eine Aussparung (12) aufweist und
wobei die Aussparung zumindest teilweise mit einem schwingungsdämpfenden Material (10) gefüllt ist und/oder in einem an die Aussparung (12) angrenzenden Bereich schwingungsdämpfendes Material (10) aufgebracht ist.

2. Gehäuse-Teil (2) nach Anspruch 1, wobei die Aussparung (12) als Nut (12) zwischen der Auflagefläche (5) und dem übrigen Gehäuse-Teil (2) ausgebildet ist.

3. Gehäuse-Teil (2) nach Anspruch 1 oder 2, wobei die Bondfläche (4) an einem Ende des Pins (3) ausgebildet ist und der Pin (3) zwischen der Bondfläche (4) und einer am gegenüberliegenden Ende des Pins angeordneten Kontaktfläche eine Biegung von zumindest näherungsweise 90° aufweist.

4. Gehäuse-Teil (2) nach einem der vorherigen Ansprüche, wobei das schwingungsdämpfende Material (10) ein Kleber (10) ist.

5. Gehäuse-Teil (2) nach einem der vorherigen Ansprüche, wobei das Gehäuse-Teil (2) mehrere unmittelbar nebeneinander angeordnete Pins (3) mit je einer Bondfläche (4) und einer Auflagefläche (5) aufweist und wobei benachbarte Auflageflächen (5) jeweils durch einen Spalt (13) voneinander getrennt sind.

6. Gehäuse-Teil (2) nach einem der vorherigen Ansprüche, aufweisend einen Kunststoff, insbesondere Epoxidharz, der mit einem Füllstoff, insbesondere Partikeln oder Glasfasern, gefüllt ist.

7. Halbleiterbauelement (1), umfassend ein Gehäuse-Teil (2) nach einem der Ansprüche 1 bis 6 sowie ein Halbleiterelement (7).

8. Halbleiterbauelement (1) nach Anspruch 7, ausgebildet als Wide Band Gap Halbleiter, insbesondere SiC Mosfest, oder Insulated-Gate Bipolar Transistor.

9. Verfahren zur Herstellung eines Gehäuse-Teils (2) zur Aufnahme eines Halbleiterelements (1),
wobei wenigstens ein Pin (3) zur elektrischen Verbindung mit einer Leiterplatte wenigstens teilweise in das Gehäuse-Teil (2) eingegossen wird,
wobei an dem Pin (3) eine Bondfläche (4) zur Herstellung einer elektrischen Verbindung zwischen dem Pin (3) und dem Halbleiterelement (7) ausgebildet wird,
wobei an dem Gehäuse-Teil (2) eine Auflagefläche (5) für die Bondfläche (4) ausgebildet wird,
wobei in dem Gehäuse-Teil (2) in der Auflagefläche (5) oder an die Auflagefläche (5) angrenzend eine Aussparung (12) ausgebildet wird und
wobei die Aussparung (12) zumindest teilweise mit einem schwingungsdämpfenden Material (10) gefüllt wird und/oder in einem an die Aussparung (12) angrenzenden Bereich schwingungsdämpfendes Material (10) aufgebracht wird.

10. Verfahren nach Anspruch 9, wobei die Aussparung (12) als Nut (12) ausgebildet wird.

11. Verfahren nach Anspruch 9 oder 10, wobei die Aussparung (12) bei der Herstellung des Gehäuse-Teils (2) in einem Spritzguss-Verfahren hergestellt wird.

12. Verfahren nach einem der Ansprüche 9 bis 11, wobei in die Aussparung (12) als schwingungsdämpfendes Material (10) ein Kleber (10) eingebracht wird.

13. Verfahren nach einem der Ansprüche 9 bis 12, wobei das Halbleiterelement (7) auf einem Halbleiter-Träger (9) aufgebracht wird und auf das Gehäuse-Teil (2) ein Kleber (10) aufgebracht wird zur Verbindung des Halbleiter-Trägers (9) mit dem Gehäuse-Teil (2), wobei in demselben Arbeitsgang der Kleber (10) in die Aussparung (12) eingebracht wird und wobei der Halbleiter-Träger (9) mittels des Klebers (10) mit dem Gehäuse-Teil (2) verklebt wird.

14. Verfahren nach einem der Ansprüche 9 bis 13, wobei das Halbleiterelement (7) eine Halbleiter-Bondfläche (8) aufweist und die Bondfläche (4) und die Halbleiter-Bondfläche (8) mittels Drahtbonden, insbesondere Ultraschall-Drahtbonden, insbesondere Ultraschall-Wedge-Wedge-Bonden, miteinander verbunden werden.

15. Verfahren zur Herstellung eines Halbleiterbauelements (1) nach Anspruch 7 oder 8 mittels eines Verfahrens nach einem der Ansprüche 9 bis 14.
